# EUROPEAN PATENT SPECIFICATION

(11) **EP 4 242 677 B1**
(45) Date of publication and mention of the grant of the patent: **29.04.2026**
(21) Application number: 23159996.0
(22) Date of filing: 03.03.2023
(51) Int. Cl.: G01R 31/367, H04Q 9/00

(54) **UNIVERSAL GAUGE MASTER SOLUTION AT MULTI-BATTERY SYSTEM**
UNIVERSELLE MESSMASTERLÖSUNG IN EINEM MEHRBATTERIESYSTEM
SOLUTION MÈRE DE JAUGE UNIVERSELLE DANS UN SYSTÈME À PLUSIEURS BATTERIES

(30) Priority: 07.03.2022 US 202263317094 P; 24.02.2023 US 202318113626
(43) Date of publication of application: 13.09.2023
(73) Proprietor: MEDIATEK INC., Hsin-Chu 300 (TW)
(72) Inventor: WU, Jui-Chi, 30078 Hsinchu City (TW); CHUANG, Jia-You, 30078 Hsinchu City (TW)
(74) Representative: Haseltine Lake Kempner LLP

(56) References cited:
- WO-A1-2018/147897
- US-A1- 2014 244 193
- US-A1- 2021 173 012

## Description

This application claims the benefit of U.S. Provisional Application No. 63/317,094, filed on March 7th, 2022.

### Background

At present, multi-battery systems have been widely used in electronic devices and peripheral components. For example, a foldable mobile phone may have two or more batteries to power different areas, a power bank may have many batteries for providing power to external device(s), and a mobile phone may communicate with surrounding earphones, watches or other measuring components in a wired or wireless way. Generally, each battery has its own fuel gauge for providing battery information such as charging state or remaining capacity, however, putting the fuel gauge in every battery will significantly increase manufacturing costs, and functionality and quality of each fuel gauge may be inconsistent.
US 2021/173012 discloses a battery management system including: a memory, a current sensor that measures a current flow through a battery to a load, a voltage sensor that measures a voltage level between a first terminal and a second terminal of the battery that are each connected to the load, and the memory, a temperature sensor that measures a temperature level of the battery; and a controller configured to be operatively connected to the current sensor, temperature sensor, and voltage sensor. The controller is configured to receive a measurement of a first current level and a first voltage level and utilize a corrected capacity and corrected open circuit voltage estimate to output an estimated open circuit voltage of the battery as compared to an estimated capacity.

### Summary

It is therefore an objective of the present invention to provide an universal gauge master method of a multi-battery system to solve the above-mentioned problems

According to one embodiment of the present invention, a multi-battery system comprising a plurality of devices and a processing circuit is disclosed. Each of the plurality of devices comprises a battery, a measurement circuit and a communication interface, wherein the measurement circuit is configured to measure the battery to generate battery information, and the communication interface is configured to transmit the battery information. The processing circuit is configured to receive the plurality of battery information of the plurality of devices, and use a universal gauge master algorithm to process the battery information of the plurality of devices to generate a plurality of gauge results, respectively.

According to one embodiment of the present invention, a processing circuit within an electronic device is configured to perform the steps of: receiving a first battery information from a first device, wherein the first battery information corresponds to a first battery within the first device; using a universal gauge master algorithm to process the first battery information to generate a first gauge result; receiving a second battery information from a second device, wherein the second battery information corresponds to a second battery within the second device; and using the universal gauge master algorithm to process the second battery information to generate a second gauge result.

These and other objectives of the present invention will no doubt become obvious to those of ordinary skill in the art after reading the following detailed description of the preferred embodiment that is illustrated in the various figures and drawings.

### Brief Description of the Drawings

FIG. 1 is a diagram illustrating a multi-battery system according to a first embodiment of the present invention.
FIG. 2 is a diagram illustrating a multi-battery system according to a second embodiment of the present invention.
FIG. 3 is a diagram illustrating a multi-battery system according to a third embodiment of the present invention.

### Detailed Description

Certain terms are used throughout the following description and claims to refer to particular system components. As one skilled in the art will appreciate, manufacturers may refer to a component by different names. This document does not intend to distinguish between components that differ in name but not function. In the following discussion and in the claims, the terms "including" and "comprising" are used in an open-ended fashion, and thus should be interpreted to mean "including, but not limited to ...". The terms "couple" and "couples" are intended to mean either an indirect or a direct electrical connection. Thus, if a first device couples to a second device, that connection may be through a direct electrical connection, or through an indirect electrical connection via other devices and connections.

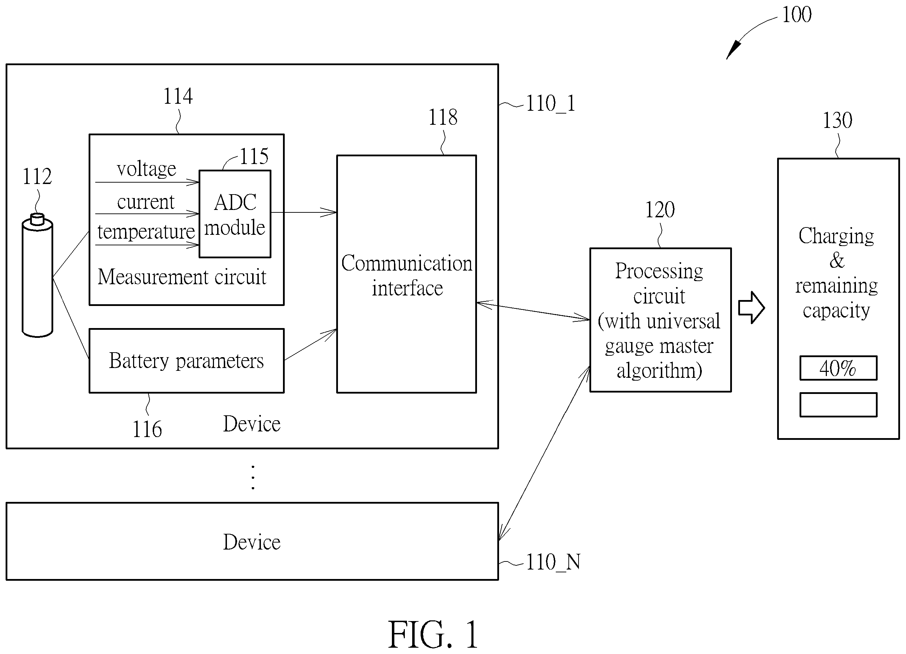

FIG. 1 is a diagram illustrating a multi-battery system 100 according to one embodiment of the present invention. As shown in FIG. 1, the multi-battery system 100 comprises a plurality of devices 110_1 - 110_N, a processing circuit 120 and a multi-media interface 130, wherein N can be any suitable positive integer greater than one. In this embodiment, each of the devices 110_1 - 110_N comprises a battery 112, a measurement circuit 114 comprising an analog-to-converter (ADC) module 115, battery parameters 116 and a communication interface 118.

In the embodiment shown in FIG. 1, each of the devices 110_1 - 110_N can be a battery pack or an electronic device comprising a battery. For example, one or more of the devices 110_1 - 110_N may be a battery pack included in a mobile phone or a tablet including the processing circuit 120. In addition, one or more of the devices 110_1 - 110_N may be an earphone, a watch or any other electronic device that can communicate with a mobile phone or a tablet including the processing circuit 120, wherein the communication interface 118 may be a Wi-Fi interface circuit or a Bluetooth interface circuit. In one embodiment, two of the devices 110_1 - 110_N are included in a mobile phone including the processing circuit 120, that is the two devices are two battery packs. In another embodiment, the device 110_1 is included in a mobile phone including the processing circuit 120, and the device 110_2 is an earphone or a watch that is wirelessly connected to the mobile phone.

In the operation of the device 110_1, the measurement circuit 114 is configured to measure a voltage, a current and a temperature of the battery 112, and the ADC module 115 performs an analog-to-digital conversion operation on the voltage, the current and the temperature of the battery 112 to generate corresponding digital codes, respectively. Specifically, the measurement circuit 114 can measure a voltage at an anode of the battery 112 to obtain the voltage of the battery; the measurement circuit 114 can measure a cross voltage of a sensing resistor, and calculate a current of the battery 112 according to the cross voltage and resistance of the sensing resistor; and the measurement circuit 114 can use a negative temperature coefficient thermistor to obtain the temperature of the battery 112. In addition, the ADC module 115 may comprise one or more ADCs for performing the analog-to-digital conversion operation, for example, the ADC module 115 may comprise only one ADC that performs the analog-to-digital conversion operation on the voltage, current and temperature of the battery 112 in a time-division multiplexing manner; or the ADC module 115 may comprise three ADCs for performs the analog-to-digital conversion operation on the voltage, current and temperature of the battery 112, respectively. It is noted that operations of the measurement circuit 114 are for illustratively only, not a limitation of the present invention.

In this embodiment, the device 110_1 does not have any battery fuel gauge, and the digital codes of the voltage, current and temperature of the battery 112 are transmitted to the processing circuit 120 via the communication interface 118.

In addition, the battery parameters 116 stored in the device 110_1 may comprise open circuit voltage (OCV), a maximal chemical capacity (Qmax), a battery resistance and/or any other parameters, and the battery parameters 116 are transmitted to the processing circuit 120 via the communication interface 118 when the device 110_1 is initially connected to the processing circuit 120.

Similarly, the other device(s) such as 110_N also transmits its digital codes of the voltage, the current and the temperature of the battery to the processing circuit 120.

The processing circuit 120 may be an application processor capable of executing an universal gauge master algorithm, or the processing circuit 120 may be a power management integrated circuit (PMIC) having circuits capable of performing the universal gauge master algorithm. After receiving the battery parameters and battery information such as digital codes of voltage, current and temperature of the battery 112 of the device 110_1, the processing circuit 120 can establish a battery model of the battery 112 according to the battery parameters, and use the battery model and the battery information to determine a gauge result, wherein the gauge result may comprise charging state, remaining capacity, full charge capacity, state of health, lifetime, or any other information related to the battery 112. It is noted that the generation of the above gauge results is known by a person skilled in the art, further descriptions are omitted here.

In addition, the processing circuit 120 also uses the battery model and the battery information of the other device such as 110_N to determine the gauge result of the battery within the 110_N.

After determining the gauge results of the devices, respectively, the processing circuit 120 transmits the gauge results to the following elements via the multi-media interface 130. For example, if the processing circuit 120 is within a mobile phone, the gauge results can be displayed on a screen, so that a user can see the gauge results of different devices. In another example, if the device 110_1 is within a mobile phone including the processing circuit 120, and the device 110_2 is external to the mobile phone, the processing circuit 120 can show the gauge result of the device 110_1 on a screen of the mobile phone, and transmit the gauge result of the device 110_2 to the device 110_2.

In the above embodiment shown in FIG. 1, because the battery information of the devices 110_1 - 110_N is directly transmitted to the processing circuit 120 for generating corresponding gauge results, there is no need to setup a battery fuel gauge within the device, and manufacturing costs of the devices 110_1 - 110_N are decreased. In addition, because the universal gauge master algorithm of the processing circuit 120 has more functions and better accuracy, the gauge result will be more in line with a real state of the battery.

In one embodiment, not all of the gate results of the devices 110_1 - 110_N are transmitted to the following element via the multi-media interface 130, and two or more battery information or gate results of the devices 110_1 - 110_N can be analyzed to determine an output gauge result. Specifically, the processing circuit 120 can generate an output gauge result based on the battery information or gauge results of at least two of the devices 110_1 - 110_N and a state or characteristic of the multi-battery system 100. For example, assuming that the devices 110_1 and 110_2 are two battery packs within two parts of an foldable mobile phone, if the battery power of the device 110_2 declines so much that the foldable mobile phone should be powered off or enter a power saving mode, the processing circuit 120 may generate the output gauge result mainly based on the battery information or gauge result of the device 110_2, that is the output gauge result shows that the remaining charge of the foldable mobile phone is not enough via the multi-media interface 130, even if the batter information or the gauge result of the device 110_1 indicates that its battery has enough charge.

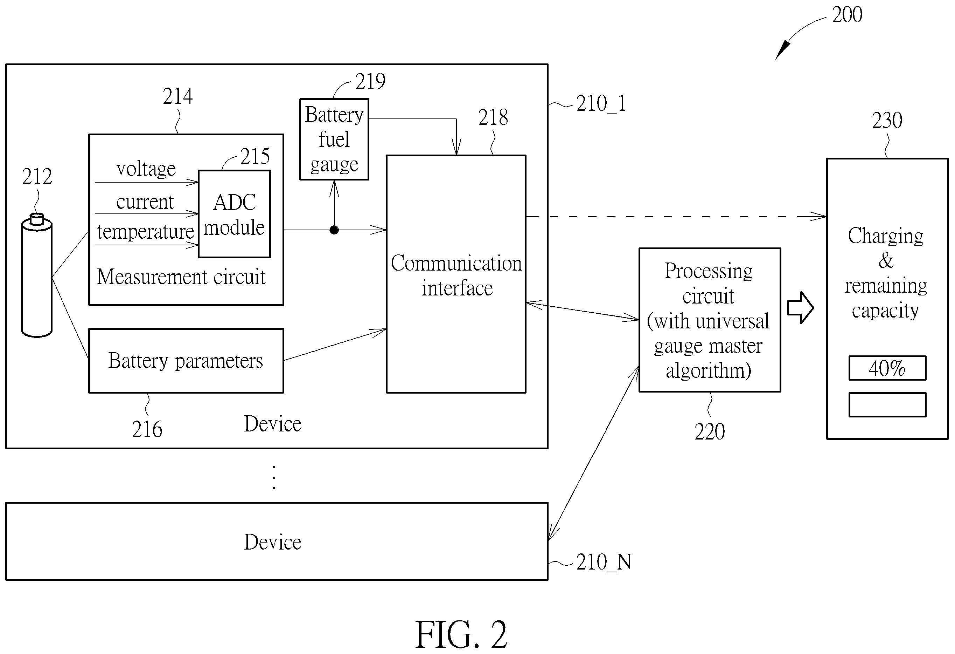

FIG. 2 is a diagram illustrating a multi-battery system 200 according to one embodiment of the present invention. As shown in FIG. 2, the multi-battery system 200 comprises a plurality of devices 210_1 - 210_N, a processing circuit 220 and a multi-media interface 230, wherein N can be any suitable positive integer greater than one. In this embodiment, each of the devices 210_1 - 210_N comprises a battery 212, a measurement circuit 214 comprising an ADC module 215, battery parameters 216, a communication interface 218 and a battery fuel gauge 219.

In the embodiment shown in FIG. 2, each of the devices 210_1 - 210_N can be a battery pack or an electronic device comprising a battery. For example, one or more of the devices 210_1 - 210_N may be a battery pack included in a mobile phone or a tablet including the processing circuit 220. In addition, one or more of the devices 210_1 - 210_N may be an earphone, a watch or any other electronic device that can communicate with a mobile phone or a tablet including the processing circuit 220. In one embodiment, two of the devices 210_1 - 210_N are included in a mobile phone including the processing circuit 220, that is the two devices are two battery packs. In another embodiment, the device 210_1 is included in a mobile phone including the processing circuit 220, and the device 210_2 is an earphone or a watch that is wirelessly connected to the mobile phone.

In the operation of the device 210_1, the measurement circuit 214 is configured to measure a voltage, a current and a temperature of the battery 212, and the ADC module 215 performs an analog-to-digital conversion operation on the voltage, current and temperature of the battery 212 to generate corresponding digital codes, respectively.

The battery fuel gauge 219 is a simple fuel gauge with less functions and accuracy, and the battery fuel gauge 219 receives the battery information such as digital codes of voltage, current and temperature of the battery 212 to generate a simple gauge result, wherein the simple gauge result may comprise charging state and remaining capacity. In addition, the battery fuel gauge 219 may transmit the simple gauge result to the following element such as multi-media interface 230 via the communication interface 218, or the battery fuel gauge 219 may transmit the simple gauge result to the processing circuit 220 via the communication interface 218.

In addition, the battery parameters 216 stored in the device 210_1 may comprise OCV, Qmax, battery resistance and/or any other parameters, and the battery parameters 216 are transmitted to the processing circuit 220 via the communication interface 218 when the device 210_1 is initially connected to the processing circuit 220.

Similarly, the other device(s) such as 210_N also transmits its digital codes of the voltage, current and temperature of the battery to the processing circuit 220.

The processing circuit 220 may be an application processor capable of executing an universal gauge master algorithm, or the processing circuit 220 may be a PMIC having circuits capable of performing the universal gauge master algorithm. After receiving the battery parameters and battery information such as digital codes of voltage, current and temperature of the battery 212 of the device 210_1, the processing circuit 220 can establish a battery model of the battery 212 according to the battery parameters, and use the battery model and the battery information to determine a gauge result, wherein the gauge result may comprise charging state, remaining capacity, full charge capacity, state of health, lifetime, or any other information related to the battery 212.

In addition, the generation of the gauge result may also refer to the simple gauge result generated by the battery fuel gauge 219.

In addition, the processing circuit 220 also uses the battery model and the battery information of the other device such as 210_N to determine the gauge result of the 210_N.

After determining the gauge results of the devices, respectively, the processing circuit 220 transmits the gauge results to the following elements via the multi-media interface 230. For example, if the processing circuit 220 is within a mobile phone, the gauge results can be displayed on a screen, so that a user can see the gauge results of different devices. In another example, if the device 210_1 is within a mobile phone including the processing circuit 220, and the device 210_2 is external to the mobile phone, the processing circuit 220 can show the gauge result of the device 210_1 on a screen of the mobile phone, and transmit the gauge result of the device 210_2 to the device 210_2.

In one embodiment, the battery fuel gate 219 can be enabled or not according the connection between the device 210_1 and the processing circuit 220. Specifically, if the processing circuit 220 is not connected to the device 210_1, the battery fuel gate 219 can be enabled to generate the simple gauge result; and if the processing circuit 220 is connected to the device 210_1, the battery fuel gate 219 can be disabled, and only the gauge result generated by the processing circuit 220 is transmitted to the multi-media interface 230.

In the above embodiment shown in FIG. 2, because the battery information of the devices 210_1 - 210_N is directly transmitted to the processing circuit 220 for generating corresponding gauge results, and the device only has a simple battery fuel gauge, the manufacturing costs of the devices 210_1 - 210_N are decreased. In addition, because the universal gauge master algorithm of the processing circuit 220 has more functions and better accuracy, the gauge result will be more in line with a real state of the battery.

In an alternative embodiment, multi-battery system 100 and the multi-battery system 200 can be combined so that part of the device(s) does not have any battery fuel gauge, and another part of the device(s) has a simple battery fuel gauge.

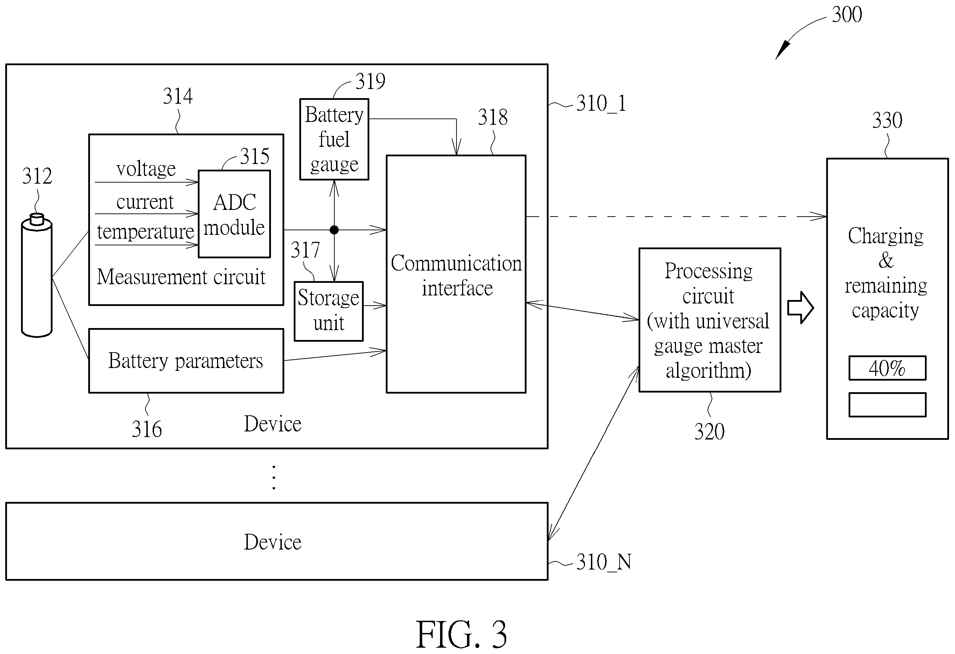

FIG. 3 is a diagram illustrating a multi-battery system 300 according to one embodiment of the present invention. As shown in FIG. 3, the multi-battery system 300 comprises a plurality of devices 310_1 - 310_N, a processing circuit 320 and a multi-media interface 330, wherein N can be any suitable positive integer greater than one. In this embodiment, each of the devices 310_1 - 310_N comprises a battery 312, a measurement circuit 314 comprising an ADC module 315, battery parameters 316, a storage unit 317, a communication interface 318 and a battery fuel gauge 319.

In the embodiment shown in FIG. 3, each of the devices 310_1 - 310_N can be a battery pack or an electronic device comprising a battery. For example, one or more of the devices 310_1 - 310_N may be a battery pack included in a mobile phone or a tablet including the processing circuit 320. In addition, one or more of the devices 310_1 - 310_N may be an earphone, a watch or any other electronic device that can communicate with a mobile phone or a tablet including the processing circuit 320. In one embodiment, two of the devices 310_1 - 310_N are included in a mobile phone including the processing circuit 320, that is the two devices are two battery packs. In another embodiment, the device 310_1 is included in a mobile phone including the processing circuit 320, and the device 310_2 is an earphone or a watch that is wirelessly connected to the mobile phone.

In the operation of the device 310_1, the measurement circuit 314 is configured to measure a voltage, a current and a temperature of the battery 312, and the ADC module 315 performs an analog-to-digital conversion operation on the voltage, current and temperature of the battery 312 to generate corresponding digital codes, respectively.

The battery fuel gauge 319 is a simple fuel gauge with less functions and accuracy, and the battery fuel gauge 319 receives the battery information such as digital codes of voltage, current and temperature of the battery 312 to generate a simple gauge result, wherein the simple gauge result may comprise charging state and remaining capacity. In addition, the battery fuel gauge 319 may transmit the simple gauge result to the following element such as multi-media interface 330 via the communication interface 318, or the battery fuel gauge 319 may transmit the simple gauge result to the processing circuit 320 via the communication interface 318.

In addition, the storage unit 317 stores a battery information history, wherein the battery information history comprises digital codes of voltage, current and temperature of the battery 312 over the past period of time (e.g., several hours or several days).

In addition, the battery parameters 316 stored in the device 310_1 may comprise OCV, Qmax, battery resistance and/or any other parameters, and the battery parameters 316 are transmitted to the processing circuit 320 via the communication interface 318 when the device 310_1 is initially connected to the processing circuit 320.

Similarly, the other device(s) such as 310_N also transmits its digital codes of the voltage, the current and the temperature of the battery to the processing circuit 320.

The processing circuit 320 may be an application processor capable of executing an universal gauge master algorithm, or the processing circuit 320 may be a PMIC having circuits capable of performing the universal gauge master algorithm. After receiving the battery parameters and battery information such as digital codes of voltage, current and temperature of the battery 312 of the device 310_1, the processing circuit 320 can establish a battery model of the battery 312 according to the battery parameters, and use the battery model and the battery information to determine a gauge result, wherein the gauge result may comprise charging state, remaining capacity, full charge capacity, state of charge, state of health, lifetime, remaining capacity history, or any other information related to the battery 312.

In addition, the processing circuit 320 also uses the battery model and the battery information of the other device such as 310_N to determine the gauge result of the 310_N.

After determining the gauge results of the devices, respectively, the processing circuit 320 transmits the gauge results to the following elements via the multi-media interface 330. For example, if the processing circuit 320 is within a mobile phone, the gauge results can be displayed on a screen, so that a user can see the gauge results of different devices. In another example, if the device 310_1 is within a mobile phone including the processing circuit 320, and the device 310_2 is external to the mobile phone, the processing circuit 320 can show the gauge result of the device 310_1 on a screen of the mobile phone, and transmit the gauge result of the device 310_2 to the device 310_2.

In the above embodiment shown in FIG. 3, because the battery information of the devices 310_1 - 310_N is directly transmitted to the processing circuit 320 for generating corresponding gauge results, and the device only has a simple battery fuel gauge, the manufacturing costs of the devices 310_1 - 310_N are decreased. In addition, because the universal gauge master algorithm of the processing circuit 320 has more functions and better accuracy, the gauge result will be more in line with a real state of the battery.

In an alternative embodiment, the multi-battery system 100, the multi-battery system 200, and/or multi-battery system 300 can be combined so that part of the device(s) does not have any battery fuel gauge, part of the device(s) has a simple battery fuel gauge, and part of the device(s) has a storage unit for storing battery information history.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A multi-battery system (100, 200, 300), comprising:
a plurality of devices (110_1, 110_2, 210_1, 210_2, 310_1, 310_2), wherein each of the plurality of devices (110_1, 110_2, 210_1, 210_2, 310_1, 310_2) comprises:
a battery (112, 212, 312);
a measurement circuit (114, 214, 314), configured to measure the battery (112, 212, 312) to generate battery (112, 212, 312) information;
a communication interface (118, 218, 318), coupled to the measurement circuit (114, 214, 314), configured to transmit the battery (112, 212, 312) information;
a processing circuit (120, 220, 320), configured to receive the plurality of battery (112, 212, 312) information of the plurality of devices (110_1, 110_2, 210_1, 210_2, 310_1, 310_2), and use a universal gauge master algorithm to process the battery (112, 212, 312) information of the plurality of devices (110_1, 110_2, 210_1, 210_2, 310_1, 310_2) to generate a plurality of gauge results, respectively;
wherein the plurality of devices (110_1, 110_2, 210_1, 210_2, 310_1, 310_2) further comprise a first device (110_1, 110_2, 210_1, 210_2, 310_1, 310_2), and the first device (110_1, 110_2, 210_1, 210_2, 310_1, 310_2) further comprises:
a battery fuel gauge (219, 319), configured to generate a simple gauge result according to the battery (112, 212, 312) information, wherein the simple gauge result comprises a charging stage and a remaining capacity of the battery within the first device;
wherein the battery fuel gauge (219, 319) transmits the simple gauge result to the processing circuit (120, 220, 320) via the communication interface (118, 218, 318).

2. The multi-battery system (100, 200, 300) of claim 1, wherein the battery (112, 212, 312) information comprises digital codes of a voltage, a current and a temperature of the battery (112, 212, 312).

3. The multi-battery system (100, 200, 300) of claim 1 or claim 2, wherein each of the plurality of devices (110_1, 110_2, 210_1, 210_2, 310_1, 310_2) comprises battery parameters (116, 216, 316), the device (110_1, 110_2, 210_1, 210_2, 310_1, 310_2) transmits the battery parameters (116, 216, 316) to the processing circuit (120, 220, 320) via the communication interface (118, 218, 318), the processing circuit (120, 220, 320) establishes a battery (112, 212, 312) model of the battery (112, 212, 312) according to the battery parameters (116, 216, 316), and the processing circuit (120, 220, 320) uses the battery (112, 212, 312) model and the battery (112, 212, 312) information to determine the gauge result.

4. The multi-battery system (100, 200, 300) of any one of claims 1 to 3, wherein the plurality of devices (110_1, 110_2, 210_1, 210_2, 310_1, 310_2) comprise a first device (110_1, 110_2, 210_1, 210_2, 310_1, 310_2) and a second device (110_1, 110_2, 210_1, 210_2, 310_1, 310_2), and the first device (110_1, 110_2, 210_1, 210_2, 310_1, 310_2) and the second device (110_1, 110_2, 210_1, 210_2, 310_1, 310_2) and the processing circuit (120, 220, 320) are within one electronic device (110_1, 110_2, 210_1, 210_2, 310_1, 310_2).

5. The multi-battery system (100, 200, 300) of any one of claims 1 to 3, wherein the plurality of devices (110_1, 110_2, 210_1, 210_2, 310_1, 310_2) comprise a first device (110_1, 110_2, 210_1, 210_2, 310_1, 310_2) and a second device (110_1, 110_2, 210_1, 210_2, 310_1, 310_2), the first device (110_1, 110_2, 210_1, 210_2, 310_1, 310_2) and the processing circuit (120, 220, 320) are within an electronic device (110**_1,** 110_2, 210_1, 210_2, 310_1, 310_2), and the second device (110_1, 110_2, 210_1, 210_2, 310_1, 310_2) is external to the electronic device (110_1, 110_2, 210_1, 210_2, 310_1, 310_2) and is wireless communicated with the electronic device (110_1, 110_2, 210_1, 210_2, 310_1, 310_2).

6. The multi-battery system (100, 200, 300) of any one of claims 1 to 3, wherein the first device (110_1, 110_2, 210_1, 210_2, 310_1, 310_2) further comprises:
a storage unit (317), configured to store battery (112, 212, 312) information history, wherein the battery (112, 212, 312) information history comprises the digital codes of voltage, current and temperature of the battery (112, 212, 312) over a past period of time;
wherein the battery (112, 212, 312) information history is transmitted to the processing circuit (120, 220, 320) via the communication interface (118, 218, 318).

7. The multi-battery system (100, 200, 300) of any one of the preceding claims, wherein the plurality of gauge results respectively correspond to the batteries of the plurality of devices (110_1, 110_2, 210_1, 210_2, 310_1, 310_2), and each of the gauge result comprises at least one of charging state, remaining capacity, full charge capacity, state of health and lifetime of the corresponding battery (112, 212, 312).

8. The multi-battery system (100, 200, 300) of any one of the preceding claims, wherein the processing circuit (120, 220, 320) generates an output gauge result according to a first gauge result and a second gauge result of the plurality of gauge results and a state or characteristic of the multi-battery system (100, 200, 300).

## Patentansprüche

1. Mehrbatteriesystem (100, 200, 300), umfassend:
eine Vielzahl von Vorrichtungen (110_1, 110_2, 210_1, 210_2, 310_1, 310_2), wobei jede der Vielzahl von Vorrichtungen (110_1, 110_2, 210_1, 210_2, 310_1, 310_2) umfasst:
eine Batterie (112, 212, 312);
eine Messschaltung (114, 214, 314), konfiguriert zum Messen der Batterie (112, 212, 312), um Batterie-(112, 212, 312)-Information zu erzeugen;
eine Kommunikationsschnittstelle (118, 218, 318), gekoppelt mit der Messschaltung (114, 214, 314), konfiguriert zum Übertragen der Batterie-(112, 212, 312)-Information;
eine Verarbeitungsschaltung (120, 220, 320), konfiguriert zum Empfangen der Vielzahl von Batterie-(112, 212, 312)-Informationen der Vielzahl von Vorrichtungen (110_1, 110_2, 210_1, 210_2, 310_1, 310_2) und zum Verwenden eines universellen Anzeige-Masteralgorithmus, um die Batterie-(112, 212, 312)-Information der Vielzahl von Vorrichtungen (110_1, 110_2, 210_1, 210_2, 310_1, 310_2) zu verarbeiten, um eine Vielzahl von Anzeigeergebnissen zu erzeugen;
wobei die Vielzahl von Vorrichtungen (110_1, 110_2, 210_1, 210_2, 310_1, 310_2) ferner eine erste Vorrichtung (110_1, 110_2, 210_1, 210_2, 310_1, 310_2) umfasst, und die erste Vorrichtung (110_1, 110_2, 210_1, 210_2, 310_1, 310_2) ferner umfasst:
eine Batterieenergieanzeige (219, 319), konfiguriert zum Erzeugen eines einfachen Anzeigeergebnisses gemäß der Batterie-(112, 212, 312)-Information, wobei das einfache Anzeigeergebnis einen Ladezustand und eine Restkapazität der Batterie innerhalb der ersten Vorrichtung umfasst;
wobei die Batterieenergieanzeige (219, 319) das einfache Anzeigeergebnis über die Kommunikationsschnittstelle (118, 218, 318) an die Verarbeitungsschaltung (120, 220, 320) überträgt.

2. Mehrbatteriesystem (100, 200, 300) nach Anspruch 1, wobei die Batterie-(112, 212, 312)-Information Digitalcodes einer Spannung, eines Stroms und einer Temperatur der Batterie (112, 212, 312) umfasst.

3. Mehrbatteriesystem (100, 200, 300) nach Anspruch 1 oder Anspruch 2, wobei jede der Vielzahl von Vorrichtungen (110_1, 110_2, 210_1, 210_2, 310_1, 310_2) Batterieparameter (116, 216, 316) umfasst, die Vorrichtung (110_1, 110_2, 210_1, 210_2, 310_1, 310_2) die Batterieparameter (116, 216, 316) über die Kommunikationsschnittstelle (118, 218, 318) an die Verarbeitungsschaltung (120, 220, 320) überträgt, die Verarbeitungsschaltung (120, 220, 320) ein Batterie-(112, 212, 312)-Modell der Batterie (112, 212, 312) gemäß den Batterieparametern (116, 216, 316) erstellt, und die Verarbeitungsschaltung (120, 220, 320) das Batterie-(112, 212, 312)-Modell und die Batterie-(112, 212, 312)-Information verwendet, um das Anzeigeergebnis zu bestimmen.

4. Mehrbatteriesystem (100, 200, 300) nach einem der Ansprüche 1 bis 3, wobei die Vielzahl von Vorrichtungen (110_1, 110_2, 210_1, 210_2, 310_1, 310_2) eine erste Vorrichtung (110_1, 110_2, 210_1, 210_2, 310_1, 310_2) und eine zweite Vorrichtung (110_1, 110_2, 210_1, 210_2, 310_1, 310_2) umfasst, und die erste Vorrichtung (110_1, 110_2, 210_1, 210_2, 310_1, 310_2) und die zweite Vorrichtung (110_1, 110_2, 210_1, 210_2, 310_1, 310_2) und die Verarbeitungsschaltung (120, 220, 320) innerhalb einer elektronischen Vorrichtung (110_1, 110_2, 210_1, 210_2, 310_1, 310_2) sind.

5. Mehrbatteriesystem (100, 200, 300) nach einem der Ansprüche 1 bis 3, wobei die Vielzahl von Vorrichtungen (110_1, 110_2, 210_1, 210_2, 310_1, 310_2) eine erste Vorrichtung (110_1, 110_2, 210_1, 210_2, 310_1, 310_2) und eine zweite Vorrichtung (110_1, 110_2, 210_1, 210_2, 310_1, 310_2) umfasst, die erste Vorrichtung (110_1, 110_2, 210_1, 210_2, 310_1, 310_2) und die Verarbeitungsschaltung (120, 220, 320) innerhalb einer elektronischen Vorrichtung (110_1, 110_2, 210_1, 210_2, 310_1, 310_2) sind, und die zweite Vorrichtung (110_1, 110_2, 210_1, 210_2, 310_1, 310_2) außerhalb der elektronischen Vorrichtung (110_1, 110_2, 210_1, 210_2, 310_1, 310_2) ist und drahtlos kommuniziert mit der elektronischen Vorrichtung (110_1, 110_2, 210_1, 210_2, 310_1, 310_2) ist.

6. Mehrbatteriesystem (100, 200, 300) nach einem der Ansprüche 1 bis 3, wobei die erste Vorrichtung (110_1, 110_2, 210_1, 210_2, 310_1, 310_2) ferner umfasst:
eine Speichereinheit (317), konfiguriert zum Speichern von Batterie-(112, 212, 312)-Informationshistorie, wobei die Batterie-(112, 212, 312)-Informationshistorie die Digitalcodes von Spannung, Strom und Temperatur der Batterie (112, 212, 312) über einen vergangenen Zeitraum umfasst;
wobei die Batterie-(112, 212, 312)-Informationshistorie über die Kommunikationsschnittstelle (118, 218, 318) an die Verarbeitungsschaltung (120, 220, 320) übertragen wird.

7. Mehrbatteriesystem (100, 200, 300) nach einem der vorhergehenden Ansprüche, wobei die Vielzahl von Anzeigeergebnissen jeweils den Batterien der Vielzahl von Vorrichtungen (110_1, 110_2, 210_1, 210_2, 310_1, 310_2) entspricht, und jedes der Anzeigeergebnisse mindestens eines von Ladezustand, Restkapazität, Vollladungskapazität, Gesundheitszustand und Lebensdauer der entsprechenden Batterie (112, 212, 312) umfasst.

8. Mehrbatteriesystem (100, 200, 300) nach einem der vorhergehenden Ansprüche, wobei die Verarbeitungsschaltung (120, 220, 320) ein Ausgabe-Anzeigeergebnis gemäß einem ersten Anzeigeergebnis und einem zweiten Anzeigeergebnis der Vielzahl von Anzeigeergebnissen und einem Zustand oder Charakteristik des Mehrbatteriesystems (100, 200, 300) erzeugt.

## Revendications

1. Système à plusieurs batteries (100, 200, 300) comprenant :
une pluralité de dispositifs (110_1, 110_2, 210_1, 210_2, 310_1, 310_2), dans lequel chacun de la pluralité de dispositifs (110_1, 110_2, 210_1, 210_2, 310_1, 310_2) comprend :
une batterie (112, 212, 312) ;
un circuit de mesure (114, 214, 314), configuré pour mesurer la batterie (112, 212, 312) afin de générer des informations de batterie (112, 212, 312) ;
une interface de communication (118, 218, 318), couplée au circuit de mesure (114, 214, 314), configurée pour transmettre les informations de batterie (112, 212, 312);
un circuit de traitement (120, 220, 320), configuré pour recevoir la pluralité d'informations de batterie (112, 212, 312) de la pluralité de dispositifs (110_1, 110_2, 210_1, 210_2, 310_1, 310_2), et utiliser un algorithme maître de jauge universel pour traiter les informations de batterie (112, 212, 312)de la pluralité de dispositifs (110_1, 110_2, 210_1, 210_2, 310_1, 310_2) afin de générer une pluralité de résultats de jauge, respectivement ;
dans lequel la pluralité de dispositifs (110_1, 110_2, 210_1, 210_2, 310_1, 310_2) comprend également un premier dispositif (110_1, 110_2, 210_1, 210_2, 310_1, 310_2), et le premier dispositif (110_1, 110_2, 210_1, 210_2, 310_1, 310_2) comprend également :
une jauge de carburant de batterie (219, 319), configurée pour générer un résultat de jauge simple selon les informations de batterie (112, 212, 312), dans lequel le résultat de jauge simple comprend une étape de charge et une capacité restante de la batterie dans le premier dispositif ;
dans lequel la jauge de carburant de batterie (219, 319) transmet le résultat de jauge simple au circuit de traitement (120, 220, 320) via l'interface de communication (118, 218, 318).

2. Système à plusieurs batteries (100, 200, 300) selon la revendication 1, dans lequel les informations de batterie (112, 212, 312) comprennent des codes numériques d'une tension, d'un courant et d'une température de la batterie (112, 212, 312).

3. Système à plusieurs batteries (100, 200, 300) selon la revendication 1 ou la revendication 2, dans lequel chacun de la pluralité de dispositifs (110_1, 110_2, 210_1, 210_2, 310_1, 310_2) comprend des paramètres de batterie (116, 216, 316), le dispositif (110_1, 110_2, 210_1, 210_2, 310_1, 310_2) transmet les paramètres de batterie (116, 216, 316) au circuit de traitement (120, 220, 320) via l'interface de communication (118, 218, 318), le circuit de traitement (120, 220, 320) établit un modèle de batterie (112, 212, 312) de la batterie (112, 212, 312) selon les paramètres de batterie (116, 216, 316), et le circuit de traitement (120, 220, 320) utilise le modèle de batterie (112, 212, 312) et les informations de batterie (112, 212, 312) pour déterminer le résultat de jauge.

4. Système à plusieurs batteries (100, 200, 300) selon l'une quelconque des revendications 1 à 3, dans lequel la pluralité de dispositifs (110_1, 110_2, 210_1, 210_2, 310_1, 310_2) comprend un premier dispositif (110_1, 110_2, 210_1, 210_2, 310_1, 310_2) et un second dispositif (110_1, 110_2, 210_1, 210_2, 310_1, 310_2), et le premier dispositif (110_1, 110_2, 210_1, 210_2, 310_1, 310_2) et le second dispositif (110_1, 110**_2,** 210**_1,** 210**_2,** 310_1, 310_2) et le circuit de traitement (120, 220, 320) se trouvent dans un seul dispositif électronique (110_1, 110_2, 210_1, 210_2, 310_1, 310_2).

5. Système à plusieurs batteries (100, 200, 300) selon l'une quelconque des revendications 1 à 3, dans lequel la pluralité de dispositifs (110_1, 110_2, 210_1, 210_2, 310_1, 310_2) comprend un premier dispositif (110_1, 110_2, 210_1, 210_2, 310_1, 310_2) et un second dispositif (110_1, 110_2, 210_1, 210_2, 310_1, 310_2), le premier dispositif (110_1, 110_2, 210_1, 210_2, 310_1, 310_2) et le circuit de traitement (120, 220, 320) se trouvent dans un dispositif électronique (110_1, 110_2, 210_1, 210_2, 310_1, 310_2), et le second dispositif (110_1, 110_2, 210_1, 210_2, 310_1, 310_2) est externe au dispositif électronique (110_1, 110_2, 210_1, 210_2, 310_1, 310_2) et communique sans fil avec le dispositif électronique (110_1, 110_2, 210_1, 210_2, 310_1, 310_2).

6. Système à plusieurs batteries (100, 200, 300) selon l'une quelconque des revendications 1 à 3, dans lequel le premier dispositif (110_1, 110_2, 210_1, 210_2, 310_1, 310_2) comprend également :
une unité de stockage (317), configurée pour stocker un historique d'informations de batterie (112, 212, 312), dans lequel l'historique d'informations de batterie (112, 212, 312) comprend les codes numériques de tension, de courant et de température de la batterie (112, 212, 312) sur une période de temps passée ;
dans lequel l'historique d'informations de batterie (112, 212, 312) est transmis au circuit de traitement (120, 220, 320) via l'interface de communication (118, 218, 318).

7. Système à plusieurs batteries (100, 200, 300) selon l'une quelconque des revendications précédentes, dans lequel la pluralité de résultats de jauge correspond respectivement aux batteries de la pluralité de dispositifs (110_1, 110_2, 210_1, 210_2, 310_1, 310_2), et chaque résultat de jauge comprend au moins l'un d'un état de charge, d'une capacité restante, d'une capacité de charge complète, d'un état de santé et d'une durée de vie de la batterie (112, 212, 312) correspondante.

8. Système à plusieurs batteries (100, 200, 300) selon l'une quelconque des revendications précédentes, dans lequel le circuit de traitement (120, 220, 320) génère un résultat de jauge de sortie selon un premier résultat de jauge et un second résultat de jauge de la pluralité de résultats de jauge et d'un état ou d'une caractéristique du système à plusieurs batteries (100, 200, 300).
